# EUROPEAN PATENT SPECIFICATION

(11) **EP 1 606 983 B1**
(45) Date of publication and mention of the grant of the patent: **20.01.2010**
(21) Application number: 04721863.1
(22) Date of filing: 19.03.2004
(51) Int. Cl.: H05K 5/06, H01L 23/10, B60R 16/02, G12B 9/02, F16B 11/00

(54) **STRUCTURAL UNIT AND METHOD FOR THE PRODUCTION OF A STRUCTURAL UNIT**
STRUKTUREINHEIT UND VERFAHREN ZUR HERSTELLUNG EINER STRUKTUREINHEIT
UNITE STRUCTURELLE ET PROCEDE DE PRODUCTION D'UNE UNITE STRUCTURELLE

(30) Priority: 21.03.2003 DE 10313832
(43) Date of publication of application: 21.12.2005
(73) Proprietor: Tyco Electronics AMP GmbH, 64625 Bensheim (DE)
(72) Inventor: BERCHTOLD, Lorenz, 90425 Nürnberg (DE); KURZEJA, Dietmar, 76316 Malsch (DE); GLASER, Karlheinz, 74223 Flein (DE)
(74) Representative: Lindner, Michael
(86) International application number: PCT/EP2004/002864
(87) International publication number: WO 2004/084598

(56) References cited:
- EP-A- 0 309 920
- FR-A- 2 655 809
- US-A- 4 629 824
- US-A- 5 689 089
- US-A1- 2002 112 870

## Description

The invention relates to a structural unit, such as a housing, having a frame and a cover with different coefficients of thermal expansion wherein the frame and the cover are simultaneously connected and sealed with an adhesive. The invention further relates to a method for producing the same.

EP 0 309 920 A2 discloses an electronic circuit apparatus of automobiles comprising a structural unit according to the preamble of claim 1. A groove is formed along all the peripheral portion of a bottom surface of a mold resin case. A projected portion is engaged to the groove which is filled with a bonding material. The bottom surface of a step portion is also covered by the bonding material when the projected portion is thrust into the groove of the mold resin case.

US 4,629,824 discloses an IC package sealing technique and US 5,689,089 relates to an electronic control module having fluid-tight seals of a polymer material which expands when wet.

In many sectors of technology, particularly in the automobile sector, housings are hermetically sealed to protect components housed therein. In the automobile sector there is especially a need for housings that remain sealed to water and oil even when the housings are exposed to adverse conditions, such as large variations in temperature. It is also necessary to dissipate heat from inside the housing, if any of the components accommodated in the housing are heat-generating components, such as electronic circuits. To remove heat from inside the housing, one face of the housing is generally constructed as a metal plate. The metal plate is thermally coupled to the heat-generating components and acts as a heat sink. The remainder of the housing is generally made of a plastic material, because forming the entire housing out of metal is expensive and complicated. Because plastic and metal have different coefficients of thermal expansion, however, the seal between the plastic and the metal deteriorates when the housing is exposed to large variations in temperature.

To account for the deterioration of the seal between the metal plate and the plastic portion of the housing, it is known to provide strips of an elastic material, such as silicone, between the plastic portion of the housing and the metal plate. The elastic material is positioned between the plastic portion of the housing and the metal plate, and then the metal plate is fastened to the plastic portion of the housing by a screw or other clamping means, which presses the metal plate into the elastic material. Positive-locking means, such as groove and tongue connections, are also used to improve the quality of the seal between the plastic portion of the housing and the metal plate. This kind of fastening and sealing, however, is complicated, requires additional production steps, and is expensive.

It is therefore an object of the invention to develop a structural unit, particularly a housing, with the aforementioned properties that can be more cost efficiently produced.

This and other objects are achieved by a structural unit having the features defined in claim 1.

The invention will be explained in greater detail below with reference to the accompanying drawings, wherein:
Fig. 1A is a schematic sectional view from a front side of a first embodiment of a structural unit according to the invention;
Fig. 1B is a schematic sectional view from a side of the structural unit of Fig. 1A;
Fig. 2 is a schematic perspective view of the structural unit of Fig. 1A;
Fig. 3A is a schematic sectional view from a front side of a second embodiment of the structural unit;
Fig. 3B is a schematic sectional view from a side of the structural unit of Fig. 3A;
Fig. 4A is a schematic perspective view of a third embodiment of the structural unit; and
Fig. 4B is a schematic sectional view of the structural unit of Fig. 4A showing the assembly of the structural unit.

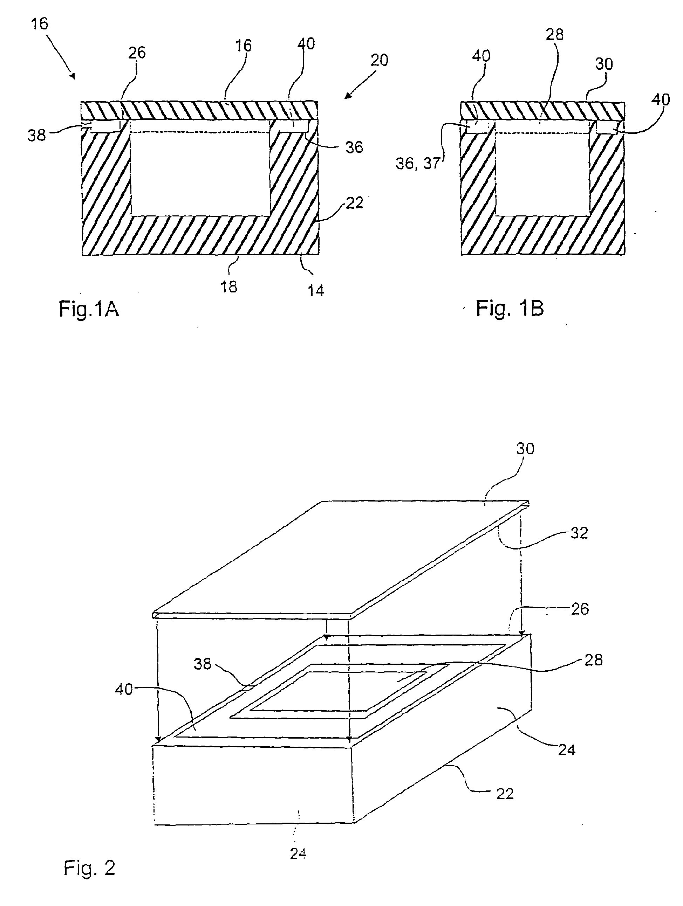

Figs. 1A and 1B show a first embodiment of a structural unit 10. The structural unit 10 includes a frame 14 and a cover 16. The term "frame" as used herein is to be understood as a structure that has a face that defines an opening and a portion that may be connected with a housing member so that a closed housing is produced. Alternatively, the portion can itself form the housing member. The term "cover" as used herein is to be understood as a structure that may cover the opening defined by the face.

As shown in Fig. 1, the structural unit 10 illustrated herein is formed as a housing 20, which can accommodate electronic components, such as a transmission control apparatus. The frame 14 of the housing 20 is formed as an essentially rectangular housing member 22. The housing member 22 is made from a plastic material by injection moulding to have a base 18 and side walls 24, as shown in Fig. 2. The side walls 24 and the base 18 form an opening 28 that extends from a connecting face 26 of the housing member 22 into an interior of the housing member 22. The housing member 22 could also be, for example, constructed as a component of the frame 14. Additionally, the housing member 22 could be any desired shape, and the opening 28 could be any desired dimension. Heat-generating components (not shown) may be accommodated in the opening 28 of the housing member 22.

As shown in Figs. 1 and 2, the cover 16 is formed as a lid 30. The lid 30 has a flat bottom surface 32. The bottom surface 32 is formed to extend essentially parallel to the connecting face 26 and may have a dimension such that it covers the opening 28 when the lid 30 is attached to the housing member 22 at the connecting face 26. The lid 30 is made from a metal material. The heat-generating components (not shown) that are accommodated in the housing member 22 may be thermally coupled to the lid 30. The lid 30 thereby conveys heat from the interior of the housing 20 to the exterior of the housing 20 by acting as a heat sink.

As shown in Fig. 1, recesses 36 are formed in the connecting face 26. The recesses 36 form a channel 37 that surrounds the opening 28 in the frame 14. The depth of the channel 37 is such that a filling compound 40, to be described later, has sufficient resilience to be able to absorb, for example, shear forces arising between the lid 30 and the housing member 22 due to thermal expansion. At least one duct 38 extends from an outside surface of the housing member 22 inward toward the channel 37 to communicate with the channel 37. In addition or alternatively, the duct 38 could extend from an inside surface of the housing member 22 outward toward the channel 37 to communicate with the channel 37.

As shown in Figure 2, a filling compound 40 is supplied in the channel 37 formed between the lid 30 and the housing member 22. The filling compound 40 illustrated herein is a hot-melt adhesive, however, other materials which may be applied at room temperature and which have similar properties may also be used. The filling compound 40 is resilient and has optimal sealing characteristics so that the filling compound 40 is capable of sealing the housing 20 and absorbing stress from the shearing forces occurring during thermal expansion of the housing member 22 and the lid 30. The filling compound 40, depending on the application, should be oil-resistant and capable of withstanding temperatures as low as minus 40 degrees Celsius. Adhesive properties of the filling compound 40 are subordinate to the sealing quality and elasticity of the filling compound 40. The filling compound 40 may be a one-component material or a two-component material. The two-component material enables the temperature of use to be above the processing temperature of the filling compound 40. Additionally, reactively cross-linking two-component filling compounds 40, polyamide based filling compound 40, or polyurethane based filling compounds 40 can be used. The polyamide based filling compounds are particularly favourable with regard to the desired properties of oil resistance, flexibility even at low minus temperatures, process ability, and resilience.

The lid 30 is attached to the housing member 22 by using an injection moulding process. The housing member 22 and the lid 30 are brought together in an injection moulding machine (not shown). To facilitate handling, the housing member 22 and the lid 30 may be tacked together to form a single unit before inserting the housing member 22 and the lid 30 in the injection moulding machine (not shown). The filling compound 40 is then heated and injected into the channel 37 via the duct 38. The filling compound 40 is injected until it fills the entire channel 37 and comes into contact with the bottom surface 32 of the lid 30. Once the filling compound 40 is cooled, the filling compound 40 firmly attaches the housing member 22 to the lid 30 and seals the opening 28 hermetically such that water, oil, or other materials can not reach the inside of the housing 20 between the lid 30 and the housing member 22.

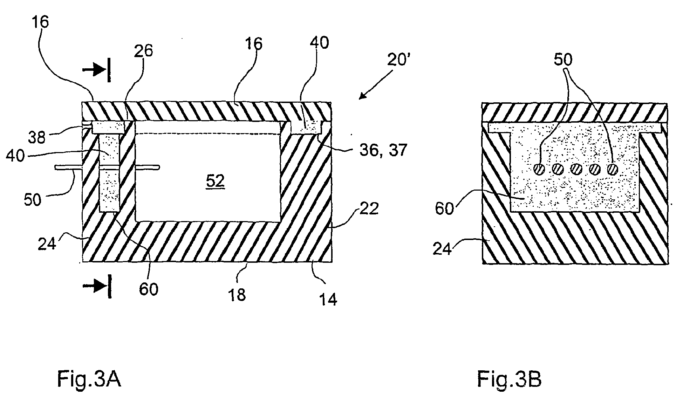

Fig 3 shows a second embodiment of the structural unit 10 formed as a housing 20'. Because the housing 20' differs only slightly from the housing 20 of Figure 1, parts of the housing 20' identical to parts of the housing 20 will be identified with identical reference numerals and further description of those parts will be omitted.

The housing 20' may be used when a lead-through, such as a contact 50, is required. For example, a contact 50 may be required when an electrical control unit (not shown) arranged inside the housing 20' has to be supplied with power and signals. As shown in Fig. 3A, the contact 50 passes completely through the side wall 24 of the housing member 22 from outside the housing 20' to an inside 52 of the housing 20'. There are various ways that the contact 50 may be passed through the side wall 24. For example, the contact may be shot through the side wall 24 or encapsulated by injection moulding during production of the housing member 22.

To achieve a seal around the contact 50, a cavity 60 is formed in the housing member 22 that extends from the channel 37 toward the base 18 of the housing member 22. The cavity 60 is formed such that it extends beyond a point where the contact 50 penetrates the side wall 24. The cavity 60 surrounds the contact 50 and extends far enough horizontally for all of the contacts 50 in the housing 20' to be located in an area of the cavity 60. Alternatively, the cavity 60 could extend through the base 18 to the outside of the housing 20'. This solution is needed, for example, when the contact 50 is encapsulated by injection moulding during production of the housing member 22.

When the filling compound 40 is injected into the channel 37, the cavity 60 also receives the filling compound 40. If the cavity 60 extends through the base 18 to the outside of the housing 20', the portion of the cavity 60 that opens to the outside of the housing 20' needs to be covered during injection of the filling compound 40. The filling compound 40 covers the portion of the contact 50 located in the cavity 60 and seals any gaps between the contact 50 and the side wall 24. As a result, any gaps in the side wall 24 are sealed simultaneously with the attachment of the lid 30 to the housing member 22.

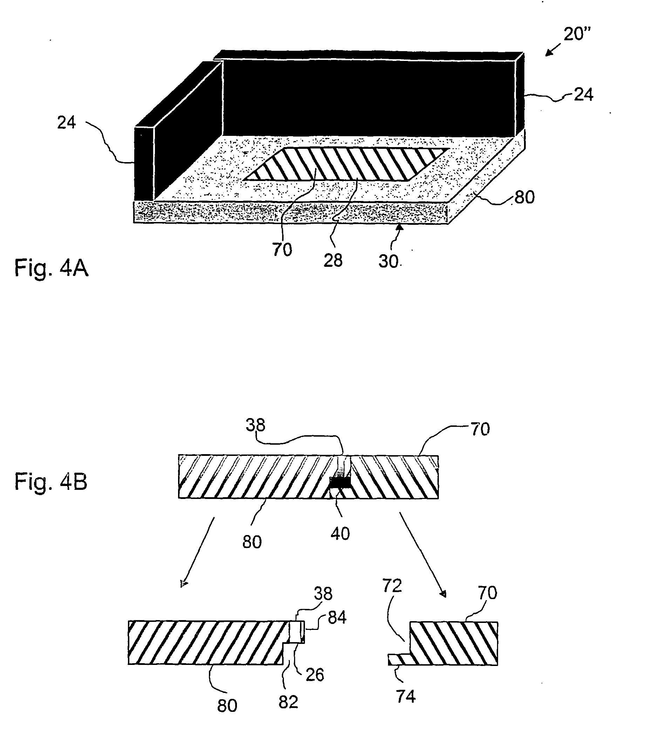

Fig. 4 shows a third embodiment of the structural unit 10 formed as a housing 20". Because the housing 20" differs only slightly from the housing 20 of Figure 1, parts of the housing 20" identical to parts of the housing 20 will be identified with identical reference numerals and further description of those parts will be omitted.

As shown in Fig. 4B, the opening 28 is partially covered by a top portion 80. The top portion 80 is made from the same material as the side walls 24 and may be integrally formed therewith. The top portion 80 has an opening 28. A cut-out 82 is formed in an edge of the top portion 80 surrounding the opening 28 to form a step part 84. The duct 38 extends from an inner surface of the step part 84 to the connecting face 26.

The lid 30 has a covering portion 70 formed to cover the opening 28. The lid 30 is made from a conductive material, for example, metal and preferably aluminium. The lid 30 is formed such that it is flush with an outer surface of the top portion 80 when received on the connecting face 26. In order to achieve a structure that is flush with the outer surface of the top portion 80, the covering portion 70 of the lid 30 has a cut-out 72 that forms a flange 74. The size of the cut-out 82 of the top portion 80 and the cut-out 72 of covering portion 70 are such that the sum of the depths of the cut-outs 82, 72 is greater than a thickness of the top portion 80 or the lid 30 to ensure that the top portion 80 and the lid 70 form a flat surface without any gaps therebetween when mated, as shown in Fig. 4B.

The top portion 80 is attached to the lid 30 in a similar manner as the lid 30 is attached to the housing member 22 in the first embodiment. Specifically, the top portion 80 is attached to the lid 30 by injecting the filling compound 40 in the duct 38 so that the filling compound 40 is received in the cut-out 82 of the top portion 80 to fill the gap formed between the connecting face 26 and the flange 74 of the lid 30.

Unlike the previous solutions, which provided separate elements for fastening and for sealing, the two functions may be achieved solely by means of the filling compound. It is therefore clear that a very simple way has been provided of connecting together two parts with different coefficients of thermal expansion, wherein at the same time the space between the two parts is sealed. Because the properties of the filling compound 40 are optimised when an appropriate volume of the filling compound 40 is provided, the connection between the two parts withstands adverse conditions, such as large temperature variations, and is sealed from fluids. Because the filling compound 40 is located in the channel 37, surface areas open to external attack are very small, making resistance to adverse environmental influences very high. Use of the structural unit 10 according to the invention in the motor vehicle sector and in the electronics sector therefore results in considerable advantages.

Additionally, the method according to the invention for connecting two parts with different coefficients of thermal expansion may be performed particularly simply and economically. Introduction of the filling compound 40, preferably a hot-melt adhesive, may be achieved with conventional injection moulding processes, wherein the frame 14 and the cover 16 in this case form the mould in the injection moulding machine. In addition, it is no longer necessary to use extra fastening elements, such as screws etc.

The foregoing illustrates some of the possibilities for practicing the invention. Many other embodiments are possible within the scope of the invention. It is, therefore, intended that the foregoing description be regarded as illustrative rather than limiting, and that the scope of the invention is given by the appended claims.

## Claims

1. A structural unit comprising a frame (14) having a connecting face (26) that surrounds an opening (28) and a cover (16) that is attached to the connecting face (26) to cover the opening (28), the frame (14) and the cover (16) being formed of materials with different coefficients of thermal expansion, wherein the connecting face (26) has a channel (37, 82) that opens towards the cover (16) for receiving a filling compound (40) attaching the cover (16, 30) to the frame (14, 80) and providing a seal therebetween, **characterised in that** at least one duct (38) communicates with the channel (37,82) such that the filling compound (40) injected into the duct (38) is received in the channel (37, 82), and **in that** a contact (50) passes through the frame (14) and at least one cavity (60) is provided in the frame (14) that communicates with the channel (37) and the contact (50) so that the filling compound (40) is received in the cavity (60) and surrounds the contact (50).

2. The structural unit according to claim 1, **characterised in that** the filling compound(40) is a two-component adhesive.

3. The structural unit according to claim 1, **characterised in that** the filling compound (40) is a reactively cross-linking adhesive.

4. The structural unit according to one of claims 1 to 3, **characterised in that** the filling compound is a polyurethane based material.

5. The structural unit according to claim 1, **characterised in that** the filling compound (40) is a polyamide based adhesive.

6. The structural unit according to one of claims 1 to 5, **characterised in that** the filling compound is a hot-melt adhesive.

7. The structural unit according to one of the preceding claims, **characterised in that** the frame (14,80) is made of a plastic material and the cover (16,30) is made of metal.

8. The structural unit according to one of the preceding claims, **characterised in that** the structural unit (10) is a housing (20).

9. The structural unit according to claim 8, **characterised in that** the housing (20) has at least one electronic component thermally coupled to the cover (16,30).

10. A method for the production of a structural unit having the stepsof :
providing a frame (14,80) having a cavity (60) and a connecting face (26) that surrounds an opening (28), the connecting face (26) having a channel (37, 82),
providing at least one contact element (50) being introduced into the frame (14) such that it penetrates the frame (14) and is received_in the cavity (60),
providing a cover (16,30) that attaches to the connecting face (26) so that it covers the opening(28), the frame (14,80) and the cover (16, 30) being made from materials with different coefficients of thermal expansion,
positioning the cover (16, 30) adjacent to the frame (14,80) such that the cover (16, 30) lies on the connecting face (26), and
injecting a filling compound (40) through at least one injection duct 38) into the channel (37,82) to connect the cover (16,30) to the frame (14,80) and seal a gap therebetween, wherein the contact element (50) is encapsulated by injection moulding when the filling compound (40) is injected into the cavity (60) and said seal is produced between the contact element(50) and the frame (14).

11. The method according to claim 10, **characterised in that** the filling compound (40) is a two-component adhesive.

12. The method according to claim 10, **characterised in that** the filling compound (40) is a reactively cross-linking adhesive.

13. The method according to claim 10, **characterised in that** the filling compound (40) is a polyamide based adhesive.

14. The method according to claim 10, **characterised in that** the filling compound (40) is a polyurethane based material.

15. The method according to one of claims 10 to 14, **characterised in that** the filling compound (40) is a hot-melt adhesive.

## Patentansprüche

1. Struktureinheit, die einen Rahmen (14) mit einer Anschlussfläche (26), die eine Öffnung (28) umgibt, und eine Abdeckung (16) aufweist, die an der Anschlussfläche (26) befestigt ist, um die Öffnung (28) abzudecken, wobei der Rahmen (14) und die Abdeckung (16) aus Materialien mit unterschiedlichen Wärmeausdehnungskoeffizienten hergestellt werden, wobei die Anschlussfläche (26) eine Auskehlung (37, 82) aufweist, die sich in Richtung der Abdeckung (16) für das Aufnehmen einer Füllmasse (40) öffnet, die die Abdeckung (16, 30) am Rahmen (14, 80) befestigt und eine Dichtung dazwischen liefert, **dadurch gekennzeichnet, dass** mindestens ein Kanal (38) mit der Auskehlung (37, 82) in Verbindung steht, so dass die in den Kanal (38) eingespritzte Füllmasse (40) im Kanal (37, 82) aufgenommen wird, und **dadurch**, dass ein Kontakt (50) durch den Rahmen (14) hindurchgeht und mindestens ein Hohlraum (60) im Rahmen (14) bereitgestellt wird, der mit dem Kanal (37) und dem Kontakt (50) in Verbindung steht, so dass die Füllmasse (40) im Hohlraum (60) aufgenommen wird und den Kontakt (50) umgibt.

2. Struktureinheit nach Anspruch 1, **dadurch gekennzeichnet, dass** die Füllmasse (40) ein Zweikomponentenklebstoff ist.

3. Struktureinheit nach Anspruch 1, **dadurch gekennzeichnet, dass** die Füllmasse (40) ein reaktiv vernetzender Klebstoff ist.

4. Struktureinheit nach Anspruch 1 bis 3, **dadurch gekennzeichnet, dass** die Füllmasse ein Material auf Polyurethanbasis ist.

5. Struktureinheit nach Anspruch 1, **dadurch gekennzeichnet, dass** die Füllmasse (40) ein Klebstoff auf Polyamidbasis ist.

6. Struktureinheit nach Anspruch 1 bis 5, **dadurch gekennzeichnet, dass** die Füllmasse ein Schmelzklebstoff ist.

7. Struktureinheit nach einem der vorhergehenden Ansprüche, **dadurch gekennzeichnet, dass** der Rahmen (14, 80) aus einem Kunststoffmaterial und die Abdeckung (16, 30) aus Metall hergestellt sind.

8. Struktureinheit nach einem der vorhergehenden Ansprüche, **dadurch gekennzeichnet, dass** die Struktureinheit (10) ein Gehäuse (20) ist.

9. Struktureinheit nach Anspruch 8, **dadurch gekennzeichnet, dass** das Gehäuse (20) mindestens ein elektronisches Bauelement aufweist, das mit der Abdeckung (16, 30) thermisch verbunden ist.

10. Verfahren zur Herstellung einer Struktureinheit, das die folgenden Schritte aufweist:
Bereitstellen eines Rahmens (14, 80) mit einem Hohlraum (60) und einer Anschlussfläche (26); die eine Öffnung (28) umgibt, wobei die Anschlussfläche (26) eine Auskehlung (37, 82) aufweist;
Bereitstellen von mindestens einem Kontaktelement (50), das in den Rahmen (14) so eingeführt wird, dass es den Rahmen (14) durchdringt und im Hohlraum (60) aufgenommen wird;
Bereitstellen einer Abdeckung (16, 30), die an der Anschlussfläche (26) so angebracht ist, dass sie die Öffnung (28) bedeckt, wobei der Rahmen (14, 80) und die Abdeckung (16, 30) aus Materialien mit unterschiedlichen Wärmeausdehnungskoeffizienten hergestellt werden;
Positionieren der Abdeckung (16, 30) angrenzend an den Rahmen (14, 80), so dass die Abdeckung (16, 30) auf der Anschlussfläche (26) liegt; und
Einspritzen einer Füllmasse (40) durch mindestens einen Einspritzkanal (38) in die Auskehlung (37, 82), um die Abdeckung (16, 30) mit dem Rahmen (14, 80) zu verbinden und einen Spalt dazwischen abzudichten, wobei das Kontaktelement (50) durch Spritzgießen eingekapselt wird, wenn die Füllmasse (40) in den Hohlraum (60) eingespritzt und die Dichtung zwischen dem Kontaktelement (50) und dem Rahmen (14) hergestellt wird.

11. Verfahren nach Anspruch 10, **dadurch gekennzeichnet, dass** die Füllmasse (40) ein Zweikomponentenklebstoff ist.

12. Verfahren nach Anspruch 10, **dadurch gekennzeichnet, dass** die Füllmasse (40) ein reaktiv vernetzender Klebstoff ist.

13. Verfahren nach Anspruch 10, **dadurch gekennzeichnet, dass** die Füllmasse (40) ein Klebstoff auf Polyamidbasis ist.

14. Struktureinheit nach Anspruch 10, **dadurch gekennzeichnet, dass** die Füllmasse (40) ein Material auf Polyurethanbasis ist.

15. Verfahren nach einem der Ansprüche 10 bis 14, **dadurch gekennzeichnet, dass** die Füllmasse (40) ein Schmelzklebstoff ist.

## Revendications

1. Unité structurale, comprenant un cadre (14) comportant une face de connexion (26) entourant une ouverture (28) et un élément de couverture (16) fixé sur la face de connexion (26) pour recouvrir l'ouverture (28), le cadre (14) et l'élément de couverture (16) étant composés de matériaux présentant des coefficients de dilatation thermique différents, la face de connexion (26) comportant un canal (37, 82) ouvert vers le couvercle (16), pour recevoir une matière de remplissage (40) fixant l'élément de couverture (16, 30) sur le cadre (14, 80) et établissant un joint d'étanchéité entre eux, **caractérisée en ce qu'**au moins un conduit (38) communique avec le canal (37, 82), de sorte que la matière de remplissage (40) injectée dans le conduit (38) est reçue dans le canal (37, 82), un contact (50) passant à travers le cadre (14), au moins une cavité (60) étant formée dans le cadre (14), communiquant avec le canal (37) et le contact (50), de sorte que la matière de remplissage (40) est reçue dans la cavité 60 et entoure le contact (50).

2. Unité structurale selon la revendication 1, **caractérisé en ce que** la matière de remplissage (40) est un adhésif à deux composants.

3. Unité structurale selon la revendication 1, **caractérisée en ce que** la matière de remplissage (40) est un adhésif à réticulation par réaction.

4. Unité structurale selon l'une des revendications 1 à 3, **caractérisée en ce que** la matière de remplissage est un matériau à base de polyuréthane.

5. Unité structurale selon la revendication 1, **caractérisée en ce que** la matière de remplissage (40) est un adhésif à base de polyamide.

6. Unité structurale selon l'une des revendications 1 à 5, **caractérisée en ce que** la matière de remplissage est un adhésif thermofusible.

7. Unité structurale selon l'une des revendications précédentes, **caractérisée en ce que** le cadre (14; 80) est composé d'un matériau plastique, l'élément de couverture (16, 30) étant composé de métal.

8. Unité structurale selon l'une des revendications précédentes, **caractérisée en ce que** l'unité structurale (10) est un boîtier (20).

9. Unité structurale selon la revendication 8, **caractérisée en ce que** le boîtier (20) comporte au moins un composant électronique, accouplé thermiquement au couvercle (16, 30).

10. Procédé de production d'une unité structurale, comprenant les étapes ci-dessous :
fourniture d'un cadre (14, 80), comportant une cavité (60) et une face de connexion (26) entourant une ouverture (28), la face de connexion (26) comportant un canal (37, 82) ;
fourniture d'au moins un élément de contact (50), introduit dans le cadre (14), de sorte à pénétrer dans le cadre (14) et à être reçu dans la cavité (60) ;
fourniture d'un élément de couverture (16, 30) fixé sur la face de connexion (26), de sorte à recouvrir l'ouverture (28), le cadre (14, 80) et l'élément de couverture (16, 30) étant composés de matériaux présentant des coefficients de dilatation thermique différents ;
positionnement de l'élément de couverture (16, 30) près du cadre (14, 80), de sorte que l'élément de couverture (16, 30) repose sur la face de connexion (26) ; et
injection d'une matière de remplissage (40) à travers au moins un conduit d'injection (38) dans le canal (37, 82) pour connecter l'élément de couverture (16, 30) au cadre (14, 80) et fermer de manière étanche un espace entre eux, l'élément de contact (50) étant encapsulé par moulage par injection lorsque la matière de remplissage (40) est injectée dans la cavité (60), ledit joint d'étanchéité étant établi entre l'élément de contact (50) et le cadre (14).

11. Procédé selon la revendication 10, **caractérisé en ce que** la matière de remplissage (40) est un adhésif à deux composants.

12. Procédé selon la revendication 10, **caractérisé en ce que** la matière de remplissage (40) est un adhésif à réticulation par réaction.

13. Procédé selon la revendication 10, **caractérisé en ce que** la matière de remplissage (40) est un adhésif à base de polyamide.

14. Procédé selon la revendication 10, **caractérisé en ce que** la matière de remplissage (40) est un matériau à base de polyuréthane.

15. Procédé selon l'une des revendications 10 à 14, **caractérisé en ce que** la matière de remplissage (40) est un adhésif thermofusible.
